# EUROPEAN PATENT APPLICATION

(11) **EP 3 211 683 A1**
(43) Date of publication of application: **30.08.2017**
(21) Application number: 15852121.1
(22) Date of filing: 20.10.2015
(51) Int. Cl.: H01L 51/52, H01L 27/32, H01L 51/56

(54) **TOP EMISSION OLED DEVICE AND MANUFACTURING METHOD THEREOF, AND DISPLAY DEVICE**

(30) Priority: 22.10.2014 CN 201410569281
(71) Applicant: BOE Technology Group Co., Ltd., Beijing 100015 (CN)
(72) Inventor: DAI, Qing, Beijing 100176 (CN); LIU, Ze, Beijing 100176 (CN)
(74) Representative: Potter Clarkson LLP
(86) International application number: PCT/CN2015/092305
(87) International publication number: WO 2016/062240

(57) **Abstract**

A top-emitting OLED device includes: a substrate; a first electrode disposed on the substrate; an organic layer disposed on the first electrode; and a second electrode disposed on the organic layer, through which light emitted from the organic layer exits from the OLED device; wherein the first electrode comprises a curved structure recessed towards the substrate. The top-emitting OLED device can reduce the viewing angle dependence of the top-emitting OLED device, so that it can prevent color difference of exiting light, narrowed visual angle of the OLED device and lateral light leakage from occurring.

## Description

### CROSS-REFERENCE TO RELATED APPLICATION

This application claims the benefit of Chinese Patent Application No. 201410569281.2 filed on October 22, 2014 in the State Intellectual Property Office of China, the whole disclosure of which is incorporated herein by reference.

### BACKGROUND OF THE INVENTION

### Field of the Invention

Embodiments of the present disclosure relate to a light-emitting device in a display device, in particular, to a top-emitting organic light-emitting diode (OLED) device, a method of manufacturing the top-emitting OLED device and a display device comprising the OLED device.

### Description of the Related Art

An organic light-emitting diode (OLED) device has advantages, such as active light-emitting, good temperature characteristic, low power consumption, fast response speed, flexibility, ultra-thin characteristic, low cost and so on, thus it is widely applied in display device.

According to its light-emitting direction, the OLED device may be divided into three types, including bottom-emitting OLED, top-emitting OLED and double-side emitting OLED. In the bottom-emitting OLED, light exits from a substrate; in the top-emitting OLED, light exits from a top of the device; in the double-side emitting OLED, light exits from both a substrate and a top of the device. Preferably, the top-emitting OLED is not affected by transparency of the substrate so that it can effectively increase an aperture ratio of the display panel and is able to narrow spectrum and improve color purity.

Although the top-emitting OLED device has a high device efficiency, it typically has a strong microcavity effect. The microcavity effect will cause a luminescent spectrum of the OLED to be changed as a viewing angle changes so that the OLED device has viewing angle dependence, thereby leading to color difference of exiting light and narrowed visual angle.

A common top-emitting OLED device generally comprises a glass substrate, a thin film transistor (TFT), a planarization layer, a bottom electrode (anode), a pixel defining layer, an organic layer and a top electrode (cathode). The bottom electrode, the organic layer and the top electrode each presents a planar structure. Light emitted from the organic layer is reflected by the bottom electrode (anode) and then exits from the top electrode (cathode).

In a traditional top-emitting OLED device, light paths through which light emitted from points at different positions in the organic layer is projected to the same viewing point are different, so that an optical path difference is produced. As a result, spectrums and intensities of the light from different light-emitting points viewed from the same viewing point are different. In other words, the spectrum and efficiency of the OLED device obviously have angle dependence. In a type of top-emitting OLED device, an optical regulating layer is added on the top electrode (typically a cathode) to regulate performance of the exiting light. The optical regulating layer may reduce the viewing angle dependence of the OLED device due to the microcavity effect to some extent, however, material of the optical regulating layer itself may absorb a part of light, thereby reducing exiting light.

In another type of top-emitting OLED device, the microcavity effect may be reduced by reducing a reflectivity of the anode, for example, for example, using Bragg (DBR) multi-layer structure as a reflective anode. However, as the DBR structure is generally formed by laminating a plurality of films having different refractive indexes alternately, it is required to control the film thickness strictly, so that the manufacturing process is relatively complex. Moreover, the microcavity may have an advantage which enhances a front light-exiting efficiency of the device, this advantage may also be weakened as the microcavity effect is reduced.

In addition, a display using the top-emitting OLED typically further comprises a color film substrate. An assembly formed by assembling the color film substrate and the above OLED has a large thickness, and light emitted from an edge of pixel of the OLED towards the color film substrate has a large exiting angle, which may cause light emitted from one pixel region of the OLED to be transmitted to the color film of adjacent pixel regions, thereby leading to lateral light leakage and thus abnormal display.

### SUMMARY OF THE INVENTION

The present disclosure aims to provide a top-emitting organic light-emitting diode (OLED) device, a method of manufacturing the top-emitting OLED device and a display device comprising the top-emitting OLED device, which are capable of improving display performance of the display device.

According to an aspect of the present disclosure, it is provided a top-emitting OLED device comprising: a substrate; a first electrode disposed on the substrate; an organic layer disposed on the first electrode; and a second electrode disposed on the organic layer, through which light emitted from the organic layer exits from the OLED device; wherein the first electrode comprises a curved structure recessed towards the substrate, and both the organic layer and the second electrode comprise respective curved structures formed on the curved structure of the first electrode.

The top-emitting OLED device according to the embodiment of the present disclosure can not only keep the microcavity effect, but also reduce the viewing angle dependence of the top-emitting OLED device, so that it can avoid color difference of exiting light and narrowed visual angle of the OLED device. Further, the OLED device according to the embodiment of the present disclosure can avoid the lateral light leakage of a display device comprising the OLED device.

According to an embodiment of the present disclosure, the first electrode further comprises a planar edge part surrounding the curved structure of the first electrode.

According to an embodiment of the present disclosure, the curved structure of the first electrode comprises a planar bottom and an inclined sidewall extending from the planar bottom.

According to an embodiment of the present disclosure, an angle α of the inclined sidewall relative to the planar bottom satisfies following condition: 0° < α ≤ 60°.

According to an embodiment of the present disclosure, the OLED device further comprises a planarization layer disposed between the substrate and the first electrode, wherein the curved structure of the first electrode is recessed into the planarization layer.

According to an embodiment of the present disclosure, the OLED device further comprises a thin film transistor disposed between the substrate and the planarization layer, wherein the edge part of the first electrode is electrically connected with the thin film transistor through a via-hole which is formed in the planarization layer.

According to an embodiment of the present disclosure, the OLED device further comprises a planarization layer and an auxiliary layer which are disposed from a side of the substrate in order between the substrate and the first electrode, wherein the curved structure of the first electrode is recessed into the auxiliary layer.

According to an embodiment of the present disclosure, the OLED device further comprises a thin film transistor disposed between the substrate and the planarization layer, wherein the edge part of the first electrode is electrically connected with the thin film transistor through via-holes which are formed in the auxiliary layer and the planarization layer respectively.

According to an embodiment of the present disclosure, the OLED device further comprises a pixel defining layer which is disposed between the first electrode and the second electrode and surrounds the organic layer.

According to an embodiment of the present disclosure, the OLED device further comprises a planarization layer disposed on the second electrode.

According to another aspect of the present disclosure, it is provided a display device comprising the top-emitting OLED device according to any one of the above embodiments.

According to a further aspect of the present disclosure, it is provided a method of manufacturing a top-emitting OLED device, comprising:
providing a substrate;
forming a planarization layer on the substrate;
forming a recessed curved portion in the planarization layer; and
depositing a first electrode on the planarization layer including the curved portion so that the first electrode comprises a curved structure covering the curved portion and a planar edge part extending from the curved structure.

According to an embodiment of the present disclosure, the method further comprises:
forming an organic layer such that it comprises a curved structure corresponding to the curved structure of the first electrode; and
depositing a second electrode on the pixel defining layer formed with the organic layer so that the second electrode comprises a curved structure corresponding to the curved structure of the organic layer.

According to another further aspect of the present disclosure, it is provided a method of manufacturing a top-emitting OLED device, comprising:
providing a substrate;
forming a planarization layer on the substrate;
forming an auxiliary layer on the planarization layer;
forming a recessed curved portion in the auxiliary layer; and
depositing a first electrode on the auxiliary layer including the curved portion so that the first electrode comprises a curved structure covering the curved portion and a planar edge part extending from the curved structure.

In order to make objects, features and advantages of the present disclosure become more apparent, it will be further described in combination with the accompanying drawings and specific embodiments below.

### BRIEF DESCRIPTION OF THE DRAWINGS

Fig.1A is a partial sectional view of a top-emitting OLED device according to an embodiment of the present disclosure;
Fig.1B is a schematic view showing exemplary paths through which light emitted from different points in the OLED device in Fig.1A is projected to a viewing point; and
Fig.2 schematically shows various steps of a method of manufacturing the OLED device as shown in Fig.1A.

### DETAILED DESCRIPTION OF PREFERRED EMBODIMENTS OF THE INVENTION

In the following detailed description, in order to facilitate the explanation, a number of specific details are explained to provide a comprehensive understanding to the embodiments of the present disclosure. However, it is obvious that one or more embodiments may be implemented without these specific details. In other cases, conventional structures and devices are shown in schematic diagrams to simplify the drawings. Moreover, the expression "disposed on" used in the specification may be meant that a component is disposed directly on another component, or that a component is disposed above another component and there is an intermediate component between the two components.

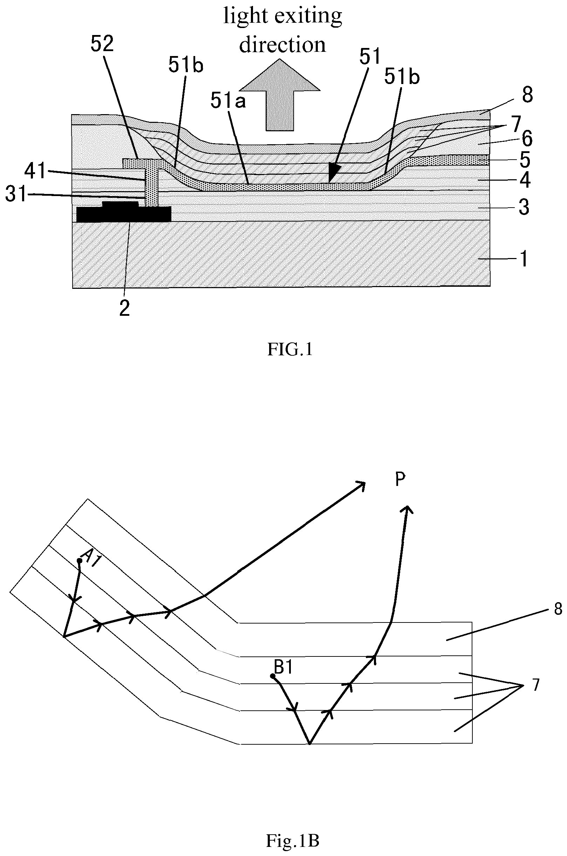

Fig.1A is a partial sectional view of a top-emitting OLED device according to an embodiment of the present disclosure, and Fig.1B is a schematic view showing exemplary paths through which light emitted from different points in the OLED device in Fig.1A is projected to a view point.

As shown in Fig.1A, the top-emitting OLED device mainly comprises: a substrate 1; a first electrode 5 such as an anode disposed on the substrate 1; an organic layer 7 disposed on the first electrode 5, the organic layer consisting of a plurality of organic sub-layers with different functions, for example, three organic sub-layers as shown in Fig.1A; and a second electrode 8 such as a cathode disposed on the organic layer 7, through which light emitted from the organic layer 7 exits. The first electrode 5 comprises a curved structure 51 recessed towards the substrate 1. Each of the organic layer 7 and the second electrode 8 comprises respective curved structures formed on the curved structure 51 of the first electrode 5.

The first electrode 5 is a reflective electrode, which is typically an anode and made from one material chosen from gold, silver, aluminum and alloy thereof. The second electrode is a transflective electrode, which is typically a cathode and made from one material chosen from gold, silver and alloy thereof.

As an example, the curved structure 51 of the first electrode 5 may comprise a planar bottom 51a and an inclined sidewall 51b extending from the planar bottom. The organic layer 7 and the second electrode 8 each may comprise respective planar bottom and inclined sidewall corresponding to the planar bottom and inclined sidewall of the curved structure 51.

A light exiting path in the OLED device having the above structures is shown in Fig.1B. Fig.1B schematically shows a part of light-transmitting paths in the organic layer 7 and the second electrode 8 in Fig.1A. As shown in Fig.1B, though a light-emitting point A1 in the inclined sidewall of the organic layer 7 has a different angle from a light-emitting point B1 in the planar bottom of the organic layer 7 with regard to a view point P, lengths of light path transmitted through the device from the two light-emitting points are actually approximately identical, so that microcavity effects are also approximate. As a result, color and brightness at the two light-emitting points are substantially the same for a viewer.

As shown in Fig.1A, the first electrode 5 may further comprise a planar edge part 52 surrounding the curved structure 51 of the first electrode.

The exemplary OLED device as shown in Fig.1A may further comprise a planarization layer 3 and an auxiliary layer 4 successively disposed from the substrate 1, between the substrate 1 and the first electrode 5. The curved structure 51 of the first electrode 5 is recessed into the auxiliary layer 4. The planarization layer 3 and the auxiliary layer 4 may have electrically insulated material, such as PI, SiO2 or the like.

Alternatively, according to another embodiment, no auxiliary layer 4 is provided. In this case, instead of forming the curved structure 51 of the first electrode 5 in the auxiliary layer 4, the curved structure 51 of the first electrode 5 is directly formed in the planarization layer 3, that is, the curved structure 51 of the first electrode 5 is recessed into the planarization layer 3. According to this embodiment, the planarization layer 3 is required to be thicker so as to prevent the curved structure 51 of the first electrode 5 from penetrating the planarization layer.

Moreover, the OLED device as shown in Fig.1A may further comprise a thin film transistor (TFT) 2 disposed between the substrate 1 and the planarization layer 3. The first electrode 5 further comprises a planar edge part 52 surrounding the curved structure 51. The edge part 52 of the first electrode 5 is electrically connected with a drain of the TFT 2 through via-holes 31, 41 which are formed in the planarization layer 3 and the auxiliary layer 4, respectively.

In the embodiment in which no auxiliary layer 4 is provided, the edge part 52 of the first electrode 5 is electrically connected with the drain of the TFT 2 through only the via-hole 31 which is formed in the planarization layer 3.

The OLED device as shown in Fig.1A may further comprise a pixel defining layer 6 which is disposed between the first electrode 5 and the second electrode 8 and surrounds the organic layer 7. The pixel defining layer 6 covers fully exposed parts of the auxiliary layer 4 and the edge part 52 of the reflective electrode 5, and an edge thereof extends to a top of the inclined sidewall 51b of the curved structure 51 of the reflective electrode 5.

The organic layer 7 may include various functional layers, such as hole injection layer, hole transport layer, light-emitting layer, electron transport layer, electron injection layer, etc., which are successively disposed from the first electrode 5. In a case of a complex device having in-series structures, it may further include a charge generating layer, a connecting layer, etc..

Though not shown, the OLED device according to an embodiment of the present disclosure may further comprise a transparent planarization layer formed on the second electrode 8 to compensate for a height difference of the second electrode in a thickness direction due to the recessed portion. Further, a color-film and transparent glass substrate may be disposed on this transparent planarization layer.

According to another further embodiment of the present disclosure, it is provided a display device comprising the OLED device according to any one of the above embodiments. The display device may be any products or components having display function, such as cellphone, tablet computer, television, display, laptop, digital frame, navigator, e-paper, etc.

According to another embodiment, it is provided a method of manufacturing a top-emitting OLED device, comprising:
providing a substrate;
forming a planarization layer on the substrate;
forming a recessed curved portion in the planarization layer; and
depositing a first electrode on the planarization layer comprising the curved portion so that the first electrode comprises a curved structure covering the curved portion and a planar edge part extending from the curved structure.

In the embodiment, the method may further comprise:
forming a pixel defining layer on the planarization layer formed with the first electrode in such a way that the pixel defining layer exposes the curved structure of the first electrode;
depositing an organic layer on the curved structure of the first electrode exposed from the pixel defining layer so that the organic layer comprises a curved structure corresponding to the curved structure of the first electrode; and
depositing a second electrode on the pixel defining layer formed with the organic layer so that the second electrode comprises a curved structure corresponding to the curved structure of the organic layer.

In the embodiment, the method may further comprise:
forming a thin film transistor (TFT) between the substrate and the planarization layer; and
forming a via-hole in the planarization layer so that the edge part of the first electrode is electrically connected with the TFT through the via-hole formed in the planarization layer.

According to another embodiment, it is provided a method of manufacturing a top-emitting OLED device, comprising:
providing a substrate;
forming a planarization layer on the substrate;
forming an auxiliary layer on the planarization layer;
forming a recessed curved portion in the auxiliary layer; and
depositing a first electrode on the auxiliary layer comprising the curved portion so that the first electrode comprises a curved structure covering the curved portion and a planar edge part extending from the curved structure.

In the embodiment, the method may further comprise:
forming a pixel defining layer on the auxiliary layer formed with the first electrode in such a way that the pixel defining layer exposes the curved structure of the first electrode;
depositing an organic layer on the curved structure of the first electrode exposed from the pixel defining layer so that the organic layer comprises a curved structure corresponding to the curved structure of the first electrode; and
depositing a second electrode on the pixel defining layer formed with the organic layer so that the second electrode comprises a curved structure corresponding to the curved structure of the organic layer.

In the embodiment, the method may further comprise:
forming a thin film transistor (TFT) between the substrate and the planarization layer; and
forming via-holes in both the auxiliary layer and the planarization layer so that the edge part of the first electrode is electrically connected with the TFT through the via-holes formed in the auxiliary layer and the planarization layer.

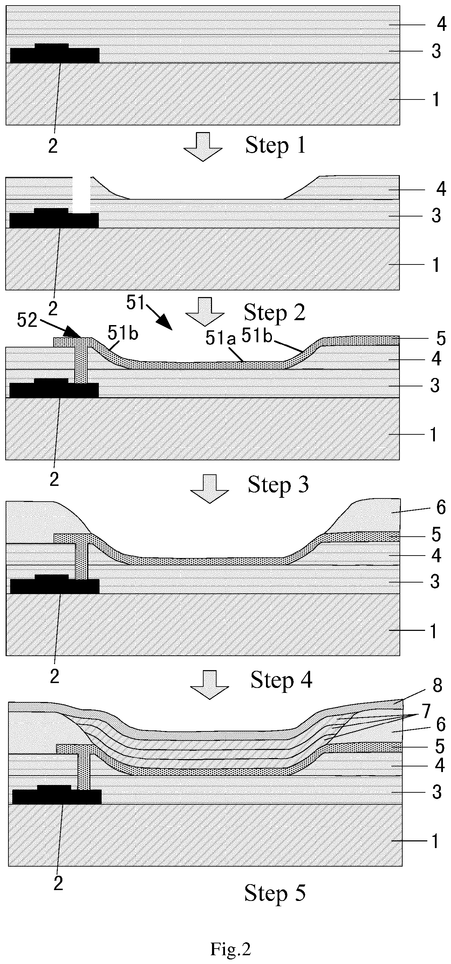

Fig.2 schematically shows various steps of a method of manufacturing the OLED device as shown in Fig.1A.

Specifically, as shown in Fig.2, the method of manufacturing the OLED device as shown in Fig.1A comprises:
Step S 1. providing a glass substrate 1 and preparing a TFT on the glass substrate 1; then forming a planarization layer 3 (for example, SiO2 layer) on the substrate 1 including the TFT 2; thereafter, depositing an auxiliary layer 4 having good electrical insulativity on the planarization layer 3, for example, the auxiliary layer 4 may be a PI layer, which has a thickness in a range of 1 to 2 µm.
Step S2. patterning the auxiliary layer 4 by means of exposing, developing and etching so as to form a recessed curved portion corresponding to a pixel aperture in the auxiliary layer 4, the curved portion comprising a planar bottom and an inclined sidewall which has a slope angle typically in a range of 0 to 60 degrees; and etching the planarization layer 3 and the auxiliary layer 4 to form via-holes 31, 41 connected with a drain of the TFT 2;
Step S3. depositing a layer of first electrode 5 having reflective function on the auxiliary layer 4 as patterned above, and patterning the layer of first electrode 5 by means of etching so that the first electrode 5 comprises a curved structure 51 covering the curved portion of the auxiliary layer 4 and a planar edge part 52 extending from the curved structure 51 and the edge part 52 is electrically connected with the drain of the TFT through the via-holes 31, 41;
Step S4. coating the patterned first electrode 5 with a pixel defining layer 6 such as PI film; then exposing, developing and etching an aperture area corresponding to the pixel aperture so that the aperture area exposes the sidewall of the curved structure 51 of the reflective electrode 5;
Step S5. depositing an organic layer 7 of the OLED on the reflective layer 5 formed with the pixel defining layer 6, for example, by means of vacuum evaporation, wherein the organic layer 7 may include various functional layers, such as hole injection layer, hole transport layer, light-emitting layer, electron transport layer, electron injection layer, etc., and in a case of a complex device having in-series structures, it may further include a charge generating layer, a connecting layer, etc.; finally depositing a top electrode 8 on the organic layer 7, wherein the top electrode 8 may be a transflective metal electrode, which is for example made from gold, silver, alloy thereof or the like.

The OLED device having the structures as shown in Fig.1A is thus formed through the above steps.

In a method of manufacturing the OLED device according to another embodiment, instead of depositing an auxiliary layer 4 on the planarization layer 3, the first electrode 5 may be prepared directly on the planarization layer 3. In this case, the planarization layer 3 is required to be thicker than common planarization layer so as to prevent the electrical insulativity of the device from being reduced after the patterning process by means of etching. Specifically, the method comprises: depositing a thick planarization layer 3 (such as SiO2 layer) on the TFT 2; then forming an aperture area of a pixel by means of photoresist protection, mask, etching and the like, a sidewall of the aperture having a certain slope angle; thereafter depositing the first electrode 5 as a reflective electrode on the planarization layer 3 and etching the first electrode 5 to pattern the first electrode 5 so that the remained first electrode 5 covers fully the aperture area of the pixel and presents a curved structure. Further, other steps in this embodiment are the same as that in the method described with reference to Fig.2.

In the OLED device according to the embodiment of the present disclosure, an angle dependence of the top-emitting OLED device can be improved by forming the anode, organic layer and cathode having respective curved structures. Further, in the OLED device according to the embodiment of the present disclosure, it is not required to add an optical regulating layer outside the top electrode so as to avoid reduced exiting light which may otherwise be caused by absorption of the regulating layer material. Compared to a process by using a plurality of Bragg diffraction layers with different thicknesses as a reflective bottom electrode, the process of manufacturing the OLED device according to the present disclosure may be simpler and may effectively utilize microcavity effect of speculum to increase an external quantum efficiency of the device while reducing angle dependence of the device, as a result, it is particularly suitable for large-scale OLED display. Compared to an OLED device having a planar structure, the OLED device having the curved structure may increase an effective light-emitting area, that is, increase an aperture ratio of the device, which allows light to be converged towards pixel center so as to increase brightness. Further, light exits along the inclined sidewall of the curved structure so that the exiting angle is reduced and thus light leaked to adjacent pixel regions is reduced.

The above embodiments only explain the principle and configuration of the present disclosure exemplarily, but do not intend to restrict the present disclosure. It should be understood for those skilled in the art that any changes and modifications made thereto without departing from the principle and spirit of the present disclosure should be within the scope of the present disclosure. The scope of the present disclosure should be defined by the appended claims and the equivalents thereof.It should be noted that phrases "comprise", "comprising", "include" and "including" do not exclude other elements or steps, and phrase "a" or "an" does not exclude a plurality of elements. In addition, any reference numerals in claims should be interpreted as limiting the scope of the present disclosure.

## Claims

1. A top-emitting OLED device, comprising:
a substrate;
a first electrode disposed on the substrate;
an organic layer disposed on the first electrode; and
a second electrode disposed on the organic layer, through which light emitted from the organic layer exits from the OLED device;
wherein the first electrode comprises a curved structure which is recessed towards the substrate, and both the organic layer and the second electrode comprise respective curved structures formed on the curved structure of the first electrode.

2. The OLED device according to claim 1, wherein the first electrode further comprises a planar edge part surrounding the curved structure of the first electrode.

3. The OLED device according to claim 1 or 2, wherein the curved structure of the first electrode comprises a planar bottom and an inclined sidewall extending from the planar bottom.

4. The OLED device according to claim 3, wherein an angle α of the inclined sidewall relative to the planar bottom satisfies following condition: 0° < α ≤ 60 ° .

5. The OLED device according to claim 2 or 3, further comprising a planarization layer disposed between the substrate and the first electrode, wherein the curved structure of the first electrode is recessed into the planarization layer.

6. The OLED device according to claim 5, further comprising a thin film transistor disposed between the substrate and the planarization layer, wherein the edge part of the first electrode is electrically connected with the thin film transistor through a via-hole which is formed in the planarization layer.

7. The OLED device according to claim 2 or 3, further comprising a planarization layer and an auxiliary layer which are successively disposed from the substrate between the substrate and the first electrode, wherein the curved structure of the first electrode is recessed into the auxiliary layer.

8. The OLED device according to claim 7, further comprising a thin film transistor disposed between the substrate and the planarization layer, wherein the edge part of the first electrode is electrically connected with the thin film transistor through via-holes which are formed in both the auxiliary layer and the planarization layer.

9. The OLED device according to any one of claims 1 to 8, further comprising a pixel defining layer which is disposed between the first electrode and the second electrode and surrounds the organic layer.

10. The OLED device according to any one of claims 1 to 9, further comprising a planarization layer disposed on the second electrode.

11. A display device comprising the top-emitting OLED device according to any one of claims 1 to 10.

12. A method of manufacturing a top-emitting OLED device, comprising:
providing a substrate;
forming a planarization layer on the substrate;
forming a recessed curved portion in the planarization layer; and
depositing a first electrode on the planarization layer comprising the curved portion so that the first electrode comprises a curved structure covering the curved portion and a planar edge part extending from the curved structure.

13. The method of manufacturing a top-emitting OLED device according to claim 12, further comprising:
forming a pixel defining layer on the planarization layer formed with the first electrode in such a way that the pixel defining layer exposes the curved structure of the first electrode;
depositing an organic layer on the curved structure of the first electrode exposed from the pixel defining layer so that the organic layer comprises a curved structure corresponding to the curved structure of the first electrode; and
depositing a second electrode on the pixel defining layer formed with the organic layer so that the second electrode comprises a curved structure corresponding to the curved structure of the organic layer.

14. The method of manufacturing a top-emitting OLED device according to claim 13, further comprising:
forming a thin film transistor between the substrate and the planarization layer; and
forming a via-hole in the planarization layer so that the edge part of the first electrode is electrically connected with the thin film transistor through the via-hole formed in the planarization layer.

15. A method of manufacturing a top-emitting OLED device, comprising:
providing a substrate;
forming a planarization layer on the substrate;
forming an auxiliary layer on the planarization layer;
forming a recessed curved portion in the auxiliary layer; and
depositing a first electrode on the auxiliary layer comprising the curved portion so that the first electrode comprises a curved structure covering the curved portion and a planar edge part extending from the curved structure.

16. The method of manufacturing a top-emitting OLED device according to claim 15, further comprising:
forming a pixel defining layer on the auxiliary layer formed with the first electrode in such a way that the pixel defining layer exposes the curved structure of the first electrode;
depositing an organic layer on the curved structure of the first electrode exposed from the pixel defining layer so that the organic layer comprises a curved structure corresponding to the curved structure of the first electrode; and
depositing a second electrode on the pixel defining layer formed with the organic layer so that the second electrode comprises a curved structure corresponding to the curved structure of the organic layer.

17. The method of manufacturing a top-emitting OLED device according to claim 16, further comprising:
forming a thin film transistor between the substrate and the planarization layer; and
forming via-holes in both the auxiliary layer and the planarization layer so that the edge part of the first electrode is electrically connected with the thin film transistor through the via-holes formed in the auxiliary layer and the planarization layer.
